Europäisches Patentamt

European Patent Office

Office européen des brevets

(19)

(11) **EP 1 019 948 B1**

(12) **EUROPÄISCHE PATENTSCHRIFT**

(45) Veröffentlichungstag und Bekanntmachung des Hinweises auf die Patenterteilung:
**15.09.2004 Patentblatt 2004/38**

(21) Anmeldenummer: **99910123.1**

(22) Anmeldetag: **10.02.1999**

(51) Int Cl.⁷: $H01J\ 61/073$, $H01J\ 9/02$

(86) Internationale Anmeldenummer:
**PCT/DE1999/000372**

(87) Internationale Veröffentlichungsnummer:
**WO 2000/008672 (17.02.2000 Gazette 2000/07)**

(54) **HOCHDRUCKLAMPE MIT LANGER LEBENSDAUER**

HIGH PRESSURE DISCHARGE LAMP WITH LONG LIFETIME

LAMPE A HAUTE PRESSION A LONGUE DUREE

(84) Benannte Vertragsstaaten:
**BE CH DE FR GB IT LI NL**

(30) Priorität: **06.08.1998 DE 19835476**

(43) Veröffentlichungstag der Anmeldung:
**19.07.2000 Patentblatt 2000/29**

(73) Patentinhaber: **Patent-Treuhand-Gesellschaft für elektrische Glühlampen mbH**
**81536 München (DE)**

(72) Erfinder: **SETZER, Carsten**
**D-13465 Berlin (DE)**

(56) Entgegenhaltungen:
**EP-A- 0 343 625**     **EP-A- 0 791 950**
**DE-A- 4 229 317**     **DE-B- 1 182 743**
**US-A- 3 982 148**

## Beschreibung

### Technisches Gebiet

Die Erfindung geht aus von einer Hochdruckentladungslampe gemäß dem Oberbegriff des Anspruchs 1. Es handelt sich dabei insbesondere um Quecksilber-Kurzbogenlampen, insbesondere für die Halbleiterindustrie. Dort werden sie häufig in photolithographischen Prozessen zur Belichtung von Wafern oder anderen Substraten benutzt. Ein weiteres bevorzugtes Anwendungsgebiet sind Edelgas-Hochdruckentladungslampen, insbesondere Xenon-Hochdruckentladungs-lampen. Auch eine Anwendung für Metallhalogenidlampen ist möglich.

### Stand der Technik

Aus der Schrift EP-A 791 950 ist bereits eine Hochdruckentladungslampe bekannt, bei der die Anode außerhalb ihrer Spitze mit einer aufgesinterten Schicht aus feinkörnigem Wolfram versehen ist. Dadurch wird die Oberfläche der Anode vergrößert. Somit kann die Temperatur der Anode im Betrieb abgesenkt werden und die Kolbenschwärzung verringert werden. Die Emissivität einer derartigen Schicht liegt bei ca. 0,5.

Aus der DE-OS 11 82 743 ist die Verwendung einer emissivitätssteigernden Schicht aus aufgesintertem Wolfram oder TaC bekannt. Die Schicht wird dabei durch Aufschlämmen einer Suspension von Butylacetat mit Zellulosebinder und dem entsprechenden Metallpulver auf die Anode aufgebracht. Der Sinterprozeß erfolgt unter Vakuum bei Temperaturen oberhalb von 1800 °C. Eine zusätzliche Kühlung kann durch die Verwendung von 1 - 3 mm tiefen Kühlriefen erzielt werden.

Aus der EP 343 625 ist eine Hochdruckentladungslampe mit Metallhalogenidfüllung bekannt, bei der der Schaft der Elektroden aus Rhenium gefertigt ist oder zumindest mit Rhenium beschichtet ist. Damit wird eine Oxidation der Schäfte bei der Herstellung vermieden.

### Darstellung der Erfindung

Es ist Aufgabe der vorliegenden Erfindung, Hochdruckentladungslampe gemäß dem Oberbegriff des Anspruchs 1 bereitzustellen, die eine sehr hohe Lebensdauer besitzt.

Diese Aufgabe wird durch die kennzeichnenden Merkmale des Anspruchs 1 gelöst. Besonders vorteilhafte Ausgestaltungen finden sich in den abhängigen Ansprüchen.

Die erfindungsgemäße Beschichtung der Oberfläche einer Elektrode eignet sich als äußerst wirksamer Mechanismus für die Kühlung der Elektrode (durch thermische Strahlung). Denn je größer der Emissionskoeffizient, desto kühler wird die Elektrode. Dadurch kann die Wolfram-Abdampfung von der Elektrode und damit die Kolbenschwärzung verringert werden. Aufgrund der exponentiellen Zunahme der Wolfram-Abdampfungsrate mit der Temperatur der Elektrode führt bereits eine vergleichsweise geringe Absenkung der Temperatur zu einer erheblichen Reduzierung der Kolbenschwärzung.

Insbesondere in der Photolithographie wird an die Lampe die Anforderung gestellt, daß der Rückgang des Lichtstromes im Laufe des Lampenbetriebes möglichst gering sein soll. Eine Alternative ist der Wunsch nach einem möglichst hohen Lichtstrom, so daß sich eine sehr kurze Belichtungszeit des Substrats erzielen läßt. Somit kann einerseits eine Verlängerung der Lebensdauer erzielt werden. Alternativ werden konstruktive Möglichkeiten eröffnet, eine höhere Anfangsintensität bei gleichbleibender Maintenance zu erreichen. Eventuell lassen sich auch die Abmessungen der Elektroden verringern.

Ursache des Rückgangs des Lichtstromes ist, daß bei einer hohen Leistungsdichte im Entladungsbogen das Elektrodenmaterial (in der Regel wird Wolfram verwendet) schmelzen und verdampfen kann. Insbesondere die Anode heizt sich durch den Aufprall der Elektronen stark auf. Von der Anode verdampfendes Wolfram schlägt sich am Kolben nieder und führt zu einer Kolbenschwärzung, die den Lichtstrom der Lampe reduziert. Aber auch bei hochbelasteten Kathoden kann die Erfindung angewendet werden.

Die Anodentemperatur hängt dabei wesentlich von der von ihr abgestrahlten Leistung ab. Betrachtet man die Anode als Planck'schen Strahler, so wird die abgestrahlte Leistung pro Fläche (L) durch das Stefan-Boltzmann-Gesetz beschrieben:

$$L : \varepsilon \times \sigma \times T^4$$

Dabei ist $\sigma = 5{,}67 \times 10^{-8}$ W m$^{-2}$ K$^{-4}$ die Stefan-Boltzmann-Konstante; der Emissionskoeffizient $\varepsilon$ beschreibt die Abweichung eines thermischen Strahlers ($0 < \varepsilon < 1$) von einem idealen schwarzen Strahler ($\varepsilon = 1$). T ist die Temperatur in K.

Bei der vorliegenden Erfindung wird durch die Beschichtung der Anode mit einem dendritischen Rhenium der Emissionskoeffizient von ca. 0,3 (reines Wolfram) auf Werte über 0,6 gesteigert (bei einer Temperatur von mindestens 1000 °C). Es werden sogar erstmals im Lampenbau Werte über 0,8 erreicht. Als dendritische Struktur wird hier eine Vielzahl nadelförmiger, strahlungsreflektierender Auswüchse auf der sonst glatten Oberfläche verstanden. Diese Auswüchse befinden sich nebeneinander in einem Abstand von einigen Manometern bis mehr als Hundert Mikrometern, bevorzugt ist ein mittlerer Abstand von mindestens 300 nm. Als besonders geeignet hat sich eine Struktur erwiesen, bei der die Tiefe des Tals zwischen zwei benachbarten nadelförmigen Spitzen mindestens 30% des Abstandes dieser Spitzen voneinander beträgt.

Besonders geeignet ist eine Rheniumschicht, da sich damit eine dendritische Struktur besonders gut erzeugen läßt. Ihr Emissionskoeffizient $\varepsilon$ beträgt ca. 0,9. Dadurch läßt sich für eine vorgegebene abgestrahlte Leistung L bei einer mit dendritischem Rhenium beschichteten Anode die Temperatur im Betrieb der Anode um bis zu 200 K reduzieren, verglichen mit einer unbeschichteten oder einer mit aufgesintertem Wolfram oder TaC beschichteten Anode. Die Eignung der Rhenium-Schicht für den Lampenbau ist insofern erstaunlich, weil der Dampfdruck des Rheniums im Vergleich zu Wolfram um etwa einen Faktor 75 höher ist. Bei einer im Vakuum betriebenen Drehanode spielt dieser Gesichtspunkt keine Rolle, da das abgedampfte Material an kalten Stellen kondensiert. Im Lampenbau würde aber die starke Abdampfung zu einer Schwärzung und damit zu einer verringerten Lebensdauer führen. Aufgrund der erheblichen Temperaturabsenkung wird dieser nachteilige Effekt jedoch mehr als ausgeglichen.

Durch diese stark verbesserte Anodenkühlung wird außerdem die Verdampfung des regulären Elektrodenmaterials (Wolfram) von der der Entladung zugewandten Ansatzfläche der Anode stark reduziert. Als Folge davon zeichnet sich die Lampe insgesamt bei gleichen lichttechnischen Daten durch einen erheblich verringerten Strahlungsrückgang im Laufe der Lebensdauer aus.

Bevorzugt ist der vordere Bereich der Anode halbkugelig oder konisch verjüngt. Besonders geeignet ist ein Kegelstumpf mit ebener Ansatzfläche für die Entladung (im folgenden Anodenplateau genannt).

Alternativ können durch die Erfindung Anoden mit kleineren Abmessungen bei gleichbleibendem Lebensdauerverhalten und gleicher Betriebstemperatur bereitgestellt werden. Durch die kleinere Abmessung wird die Abschattung des Entladungsbogens durch die Elektroden verringert, wodurch der Lichtstrom der Lampe bei gleichem Lebensdauerverhaften erhöht wird.

Beispielsweise läßt sich mittels chemischer Gasphasenepitaxie (in der Fachsprache auch als CVD (Chemical Vapor Deposition) bekannt) auf die Oberfläche der Anode eine ca. 10 bis 40 $\mu$m dicke metallische Schicht mit dendritischer Oberflächenmorphologie aufbringen. Sie ist durch nadelförmige Kristallite charakterisiert, deren Abstand voneinander typisch etwa 10-30 $\mu$m beträgt. Die nadelförmigen Kristallite stehen in etwa senkrecht auf der Oberfläche, so daß einfallende Strahlung durch Mehrfachreflexion zwischen den Seitenflächen benachbarter Kristallite nahezu vollständig absorbiert wird. Dadurch besitzt eine derartige Schicht ein hohes Absorptionsvermögen und ist schwarz. Entsprechend dem hohen Absorptionsvermögen besitzt sie einen hohen Emissionskoeffizienten bis zu $\varepsilon$ = 0,9. Die Herstellung derartiger Schichten ist in der US-A 3 982 148 in Zusammenhang mit einer Anwendung bei Drehanoden für Röntgenröhren beschrieben. Auf diese Schrift wird ausdrücklich bezug genommen. Als Herstellverfahren für diese Schicht eignet sich vor allem die CVD-Technik. Aber auch andere Techniken zur Herstellung dünner, hochschmelzender, metallischer Schichten wie z.B. das Sputtern (in der Fachsprache oft als PVD (Physical Vapor Deposition) bezeichnet) oder Laser-Ablation kommen in Betracht.

Durch die Steigerung des Emissionskoeffizienten auf Werte bis ca. 0,9 kann die Temperatur des Anodenplateaus, vor allem in Hochdruck-Kurzbogenlampen, um bis zu 200 K gegenüber unbeschichteten Anoden abgesenkt werden.

Die vorliegende Erfindung eignet sich vor allem für Quecksilber-Hochdruckentladungslampen, mit einem Gehalt von 1 bis 60 mg/cm$^3$ Hg. Ein typischer Kaltfülldruck des beigefügten Edelgases ist 0,2 bis 5 bar. Insbesondere wird Xenon verwendet, aber auch Argon (250 mbar) eignet sich gut.

Die vorliegende Erfindung läßt sich auch auf andere Lampentypen anwenden, insbesondere auf Xenon-Hochdruckentladungslampen mit einem Kaltfülldruck bis 20 bar. Ein sehr wichtiges Anwendungsgebiet sind Hochdruckentladungslampen, die gepulst oder mit Gleichstrom betrieben werden. Denn hier ist die Belastung der Elektrode besonders hoch. Bisher schmolz das Anodenplateau in der Mitte und zeigte eine starke Gefügeänderung. Dieses Problem ist jetzt beseitigt. Grundsätzlich eignet sich die hier beschriebene Technik nicht nur für die Anoden dieser hochbelasteten Lampe, sondern auch für ihre Kathoden. Der vordere Bereich der Kathode läuft vorteilhaft spitz zu. Solche Kathoden sind aber nicht Bestandteil des vorliegenden Erfindung

## Figuren

Im folgenden soll die Erfindung anhand mehrerer Ausführungsbeispiele näher erläutert werden. Es zeigen:

Figur 1      eine     Quecksilber-Hochdruckentladungslampe

Figur 2      die beschichtete Anode der Lampe aus Figur 1

Figur 3      einen Vergleich der Anodentemperatur zweier Lampen

Figur 4      ein Beispiel einer beschichteten Kathode

Figur 5      ein weiteres Beispiel einer beschichteten Kathode

Figur 6      einen Vergleich zwischen dem Strahlungsrückgang zweier Lampen im Konstantbetrieb

Figur 7      einen Vergleich zwischen dem Strahlungsrückgang zweier Lampen im Pulsbetrieb

Figur 8.     die Pulsform für den Betrieb der Lampen der Figur 7

## Beschreibung der Zeichnungen

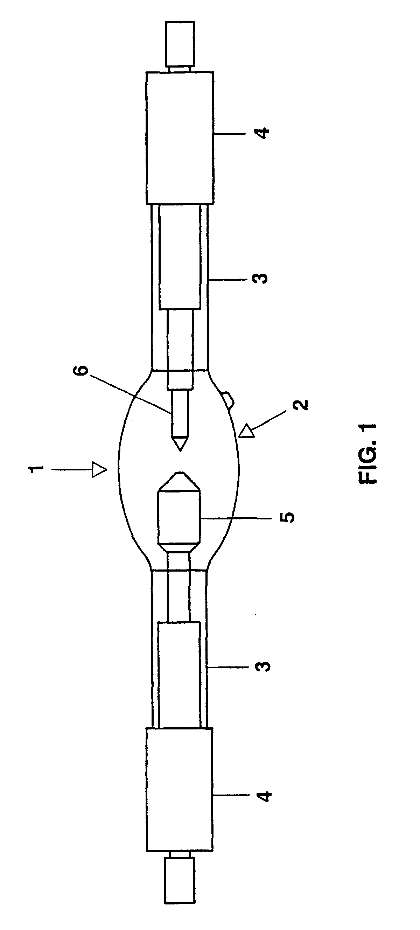

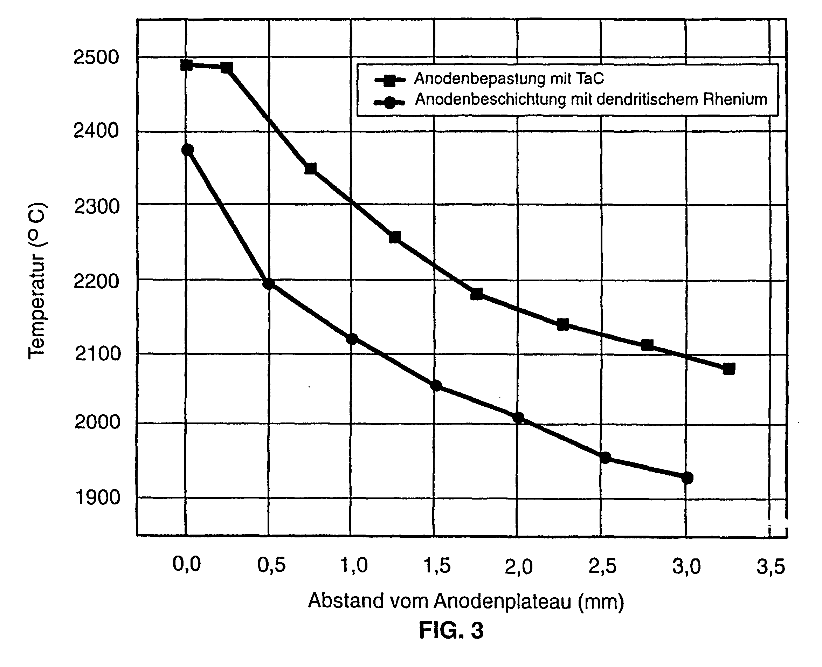

In Figur 1 ist schematisch eine Quecksilber-Hochdruckentladungslampe 1 mit einem Entladungsgefäß 2, zwei Schaftabschnitten 3 und jeweils daran befestigten Sockeln 4 gezeigt. Die Lampe wird mit einer Leistung von 1000 W unter Gleichstrom (aber auch Wechselstrom ist möglich) betrieben. Die Anode 5 und die Kathode 6 stehen einander in einem Abstand von 4,5 mm gegenüber. Das Entladungsgefäß 2 ist aus Quarzglas mit einer Wandstärke von ca. 2,8 mm gefertigt. Der Kolben ist mit 4,5 mg/cm$^3$ Quecksilber und Xenon mit einem Kaltfülldruck von 1,4 bar gefüllt. Die Betriebstemperatur des Kolbens erreicht außen Werte bis zu 750 °C.

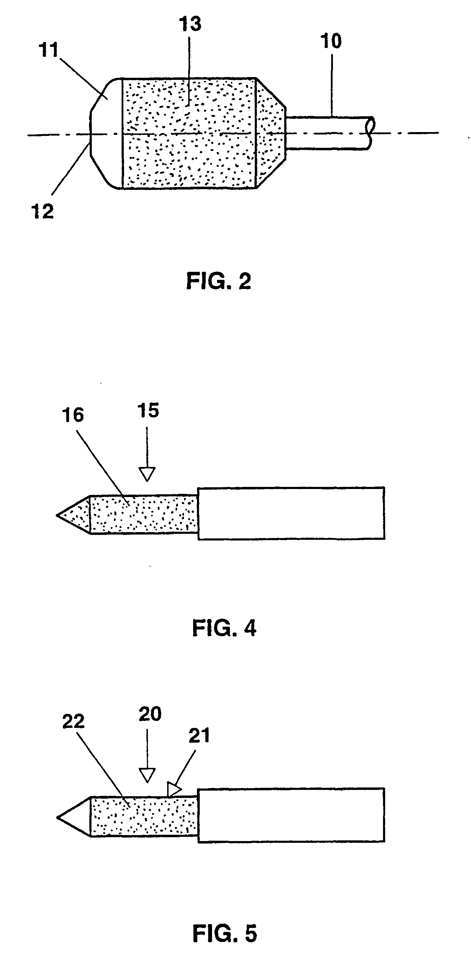

Figur 2 zeigt die Anode 5 im Detail. Auf einem Haltestab 10 sitzt der Körper der Anode 5 in Gestalt eines massiven Zylinders. An der der Entladung zugewandten Seite verjüngt sich der Zylinder, indem er konisch zuläuft. Der konische Bereich 11 endet an einem ebenen Plateau 12, dessen Durchmesser etwa 30 % des Zylinders beträgt. Der konische Bereich erstreckt sich über ein Höhe von etwa 6 mm. Der Zylinder ist mit Ausnahme seines Vorderteils, das im wesentlichen den konischen Bereich und das Plateau umfaßt, mit dendritischem Rhenium (13) beschichtet. Charakteristisch sind dafür nadelförmige Rheniumkristallite, deren Abstand voneinander etwa 10 bis 30 μm beträgt. Die Schichtdicke ist etwa 25 μm. Die nadelförmigen Kristallite stehen nahezu senkrecht auf der Oberfläche, so daß einfallende Strahlung durch Mehrfachreflexion zwischen den Seitenflächen benachbarter Kristallite nahezu vollständig absorbiert wird. Dadurch besitzt eine derartige Schicht ein hohes Absorptionsvermögen und ist schwarz. Nach dem Kirchhoffschen Strahlungsgesetz geht mit dem hohen Absorptionsvermögen ein hohes Emissionsvermögen einher. Der Emissionskoeffizient des schwarzen Rheniums ist etwa ε = 0,9. Wichtig für die Funktion ist, daß die Kristallite einerseits dicht genug stehen, andererseits das Tal zwischen den Kristalliten tief genug ist. Das Verhältnis zwischen Abstand und Höhe der einzelnen Dendriten sollte bevorzugt mindestens 0,3 betragen.

In einem anderen Ausführungsbeispiel kleinerer Leistung (unter 1000 W) ist die gesamte Anode mit Rhenium beschichtet.

Figur 3 zeigt einen Vergleich der Temperatur im Bereich des Anodenplateaus und des Zylinders bei einer Quecksilber-Kurzbogenlampe mit einer Leistung von 3500 W zwischen einer mit dendritischem Rhenium beschichteten Anode und einer mit TaC bepasteten Anode. Das Anodenplateau ist der thermisch am stärksten belastete Teil der Anode, von dem das zur Kolbenschwärzung führende Wolfram abdampft. Die Temperaturdifferenz zwischen beiden Versionen beträgt am Plateau etwa 170 °C. Diese Differenz bleibt über den gesamten vorderen Bereich der Anode (bis mindestens 3 mm Abstand vom Plateau) erhalten.

Die Figuren 4 und 5 zeigen Beispiele einer hochbelasteten Kathode 15 für eine Lampe mit hoher Leistung (3500 W), die vollständig mit einer dendritischen Rheniumschicht 16 bedeckt ist, sowie einer weniger belasteten Kathode 20 für eine Lampe mit 2500 W Leistung, bei der nur der zylindrische Körper 21 mit Rhenium 22 beschichtet ist.

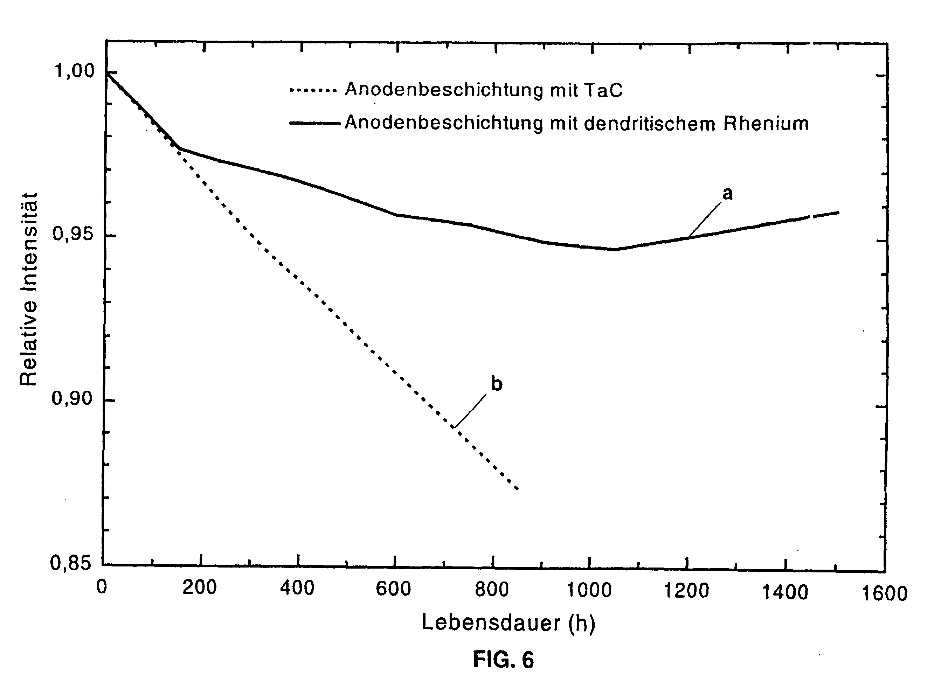

Figur 6 zeigt den Vergleich des Strahlungsrückgangs einer Quecksilber-Kurzbogenlampen, deren Anode mit dendritischem Rhenium beschichtet ist (Kurve a), zu einer baugleichen Lampe, deren Anode mit TaC beschichtet ist (Kurve b). Die Lampe wurde jeweils mit einer konstanten Leistung von 3400 W betrieben. Es wurde die gesamte Strahlungsintensität im Wellenlängenbereich 363 bis 367 nm (entsprechend der für Waferstepper besonders wichtigen "i-line") mit einer Ulbrichtkugel gemessen. Deutlich zu erkennen ist, daß die Lampe mit dendritischer Anodenbeschichtung einen wesentlich geringeren schwärzungsbedingten Strahlungsrückgang über die Lebensdauer besitzt als die Lampe mit TaC-Beschichtung auf der Anode.

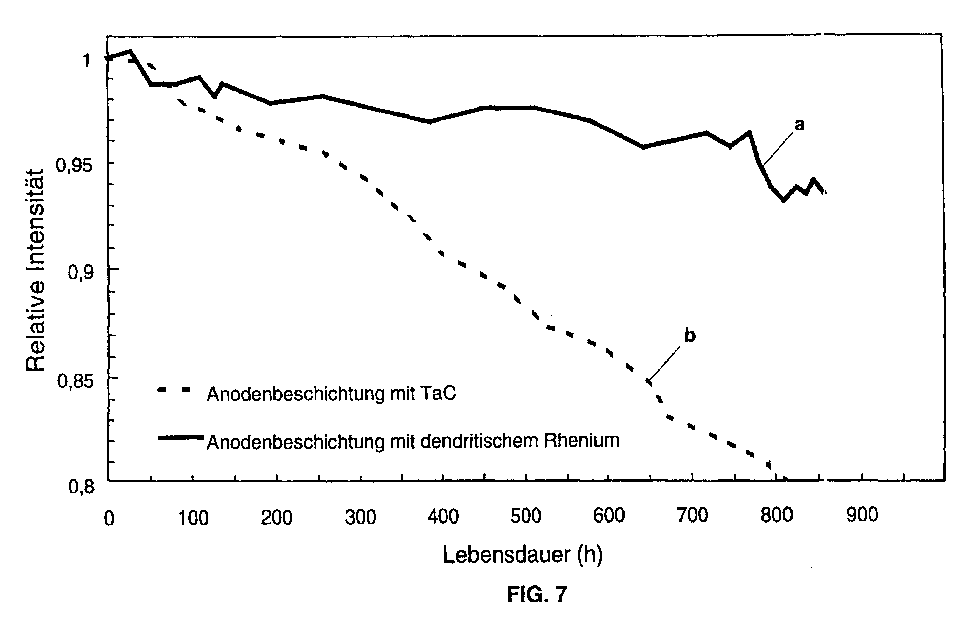

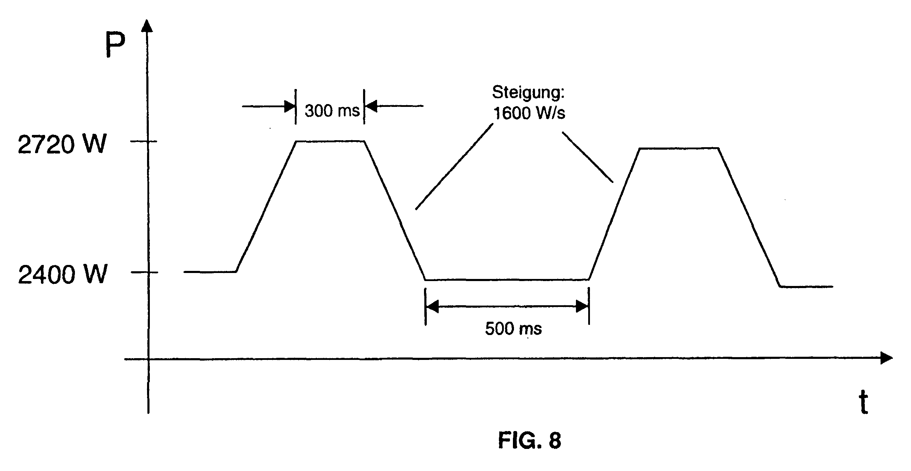

Figur 7 zeigt den Vergleich des Strahlungsrückgangs (wieder im Bereich der "i-line") einer Quecksifber-Kurzbogenlampen, deren Anode mit dendritischem Rhenium beschichtet ist (Kurve a), zu einer baugleichen Lampe (Kurve b), deren Anode mit TaC beschichtet ist, im Pulsbetrieb. Darunter ist ein Betrieb zu verstehen, bei dem die Leistung zwischen mindestens zwei Werten periodisch verändert wird, wodurch die Elektroden extrem stark belastet werden. Im gezeigten Ausführungsbeispiel wird die Quecksilberdampflampe jeweils für 300 ms mit 2720 W betrieben und für 500 ms mit 2400 W. Die Abfolge der Pulse ist schematisch in Figur 8 dargestellt. Die Leistung wird jeweils linear mit 1600 W/s verändert. Dadurch ergibt sich ein trapezförmig gepulstes Leistungssignal. Bei diesem Leistungsbetrieb ist die Schwärzung der Lampen stärker als im Betrieb mit konstanter Leistung. Auch hier zeigt die Lampe mit dendritischer Beschichtung der Anode ein deutlich besseres Lebensdauerverhalten (geringere Schwärzung) als die Lampe mit TaC-Bepastung auf der Anode.

**Patentansprüche**

1. Hochdruckentladungslampe (1) mit einem Entladungsgefäß und einer Füllung, wobei als Elektroden eine Kathode und eine Anode verwendet werden, wobei die Anode einen Schaft (10) und einen zylindrischen Kopfkörper (5) besitzt, dessen Vorderteil sich verjüngt (11), wobei die Elektroden und die Füllung im Entladungsgefäß enthalten sind, wobei die Füllung Quecksilber und/oder Edelgas enthält, **dadurch gekennzeichnet, dass** ein Teil der Oberfläche des Kopfkörpers (5), der im entladungsabgewandten Bereich liegt und wobei das Vorderteil ausgenommen ist, mit einer dendritischen Schicht (13) aus hochschmelzendem Rhenium bedeckt ist.

2. Hochdruckentladungslampe nach Anspruch 1, **da-**

**durch gekennzeichnet, daß** die dendritische Schicht zwischen 10 und 40 μm dick ist.

3. Hochdruckentladungslampe nach Anspruch 1, **dadurch gekennzeichnet, daß** die Füllung Quecksilber enthält mit einem Gehalt an Quecksilber von 1 bis 60 mg/cm$^3$ Hg.

4. Hochdruckentladungslampe nach Anspruch 1, **dadurch gekennzeichnet, daß** der Vorderteil sich konisch verjüngt und ein ebenes Plateau (12) quer zur Achse des zylindrischen Körpers besitzt.

**Claims**

1. High-pressure discharge lamp (1) having a discharge vessel and a filling, a cathode and an anode being used as the electrodes, the anode having a shaft (10) and a cylindrical top part (5), whose front part is tapered (11), the electrodes and the filling being contained in the discharge vessel, the filling containing mercury and/or a noble gas, **characterized in that** part of the surface of the top body (5), which is in the region which is remote from the discharge, and where the front part has been removed, is covered with a dendritic layer (13) made of high-melting rhenium.

2. High-pressure discharge lamp according to Claim 1, **characterized in that** the dendritic layer is between 10 and 40 μm thick.

3. High-pressure discharge lamp according to Claim 1, **characterized in that** the filling contains mercury and has a mercury content of from 1 to 60 mg/cm$^3$ Hg.

4. High-pressure discharge lamp according to Claim 1, **characterized in that** the front part is tapered conically and has a flat plateau (12) transverse with respect to the axis of the cylindrical body.

**Revendications**

1. Lampe (1) à décharge à haute pression, comprenant une enceinte de décharge et une atmosphère, une cathode et une anode étant utilisées comme électrodes, l'anode ayant un fût (10) et une tête (5) cylindrique, dont la partie avant se rétrécit (11), les électrodes et l'atmosphère étant contenues dans l'enceinte de décharge, l'atmosphère contenant du mercure et/ou du gaz rare, **caractérisée en ce qu'**une partie de la surface de la tête (5) qui se trouve dans la zone éloignée de la décharge et dont la partie avant est exclue, est revêtue d'une couche (13) dendritique de rhénium à haut point de fusion.

2. Lampe à décharge à haute pression suivant la revendication 1, **caractérisée en ce que** la couche dendritique a une épaisseur comprise entre 10 et 40 μm.

3. Lampe à décharge à haute pression suivant la revendication 1, **caractérisée en ce que** l'atmosphère contient du mercure avec une teneur en mercure de 1 à 60 mg/cm$^3$ de Hg.

4. Lampe à décharge à haute pression suivant la revendication 1, **caractérisée en ce que** la partie avant se rétrécit coniquement et a un plateau (12) plan transversalement à l'axe de la tête cylindrique.

FIG. 1

FIG. 3

**FIG. 2**

**FIG. 4**

**FIG. 5**

FIG. 6

FIG. 7

FIG. 8

Steigung:
1600 W/s

300 ms

500 ms

2720 W

2400 W

P

t

EP 1 019 948 B1